# EUROPÄISCHE PATENTSCHRIFT

(11) **EP 1 066 743 B1**
(45) Veröffentlichungstag und Bekanntmachung des Hinweises auf die Patenterteilung: **08.05.2002**
(21) Anmeldenummer: 98965082.5
(22) Anmeldetag: 18.11.1998
(51) Int. Cl.: H05K 13/04

(54) **VERFAHREN UND VORRICHTUNG ZUM OPTISCHEN ÜBERPRÜFEN EINES ELEKTRISCHEN BAUELEMENTES AN EINEM BESTÜCKKOPF**
METHOD AND DEVICE FOR OPTICALLY CHECKING AN ELECTRIC COMPONENT ON A COMPONENT INSERTION HEAD
PROCEDE ET DISPOSITIF POUR LE CONTROLE OPTIQUE D'UN COMPOSANT ELECTRIQUE MAINTENU SUR UNE TETE DE MISE EN PLACE DE COMPOSANTS

(30) Priorität: 26.03.1998 DE 19813506
(43) Veröffentlichungstag der Anmeldung: 10.01.2001
(73) Patentinhaber: SIEMENS AKTIENGESELLSCHAFT, 80333 München (DE)
(72) Erfinder: REIMANN, Günter, D-81375 München (DE); JONKE, Gerhard, D-82205 Gilching (DE); KORNEK, Rudolf, D-86316 Friedberg (DE)
(86) Internationale Anmeldenummer: DE9803415
(87) Internationale Veröffentlichungsnummer: WO9949713

(56) Entgegenhaltungen:
- EP-A- 0 632 496
- US-A- 5 570 993

## Beschreibung

Die Erfindung bezieht sich auf ein Verfahren und eine Vorrichtung zum optischen Überprüfen eines elektrischen Bauelementes, das an einer Saugpipette eines Bestückkopfes eines Bestückautomaten zur Bestückung von Bauelementeträgern gehalten wird.

Bisher war es üblich, die Anwesenheit eines Bauelementes an einer Saupipette mittels einer Lichtschranke zu überprüfen, bei der ein optischer Sende eine Intensitätsänderung der empfangenen Lichtimpulse detektiert. Je nach Art und Dicke der zu bestückenden Bauteile können die Saupipetten unterschiedlich lang und dick sein. Insbesondere bei kleinen Bauelementen ist es daher schwierig, eine Stelle zu finden, an der dieses vom Sensor sicher erfaßt wird.

Durch die US-A-5 570 993 ist ein Verfahren zum optischen Überprüfen eines Bauelementes bekannt mit einem Liniensensor bekannt, dessen Längsrichtung sich senkrecht zur Achsrichtung der Saugpipette erstreckt. Dabei kann aus der Länge der Abschattung die Breite des Bauteils ermittelt werden.

Der Erfindung liegt die Aufgabe zugrunde, die Erkennungssicherheit zu erhöhen und die Auswertung zu vereinfachen. Diese Aufgabe wird durch die Erfindung gemäß Anspruch 1 gelöst.

Durch die Verwendung eines Liniensensors der parallel zur Achsrichtung der Saugpipette orientiert ist, kann die Länge der Abschattung genau gelesen werden. Es versteht sich, daß auf der dem Sensor diametral gegenüberliegenden Seite der Saugpipette eine Lichtquelle angeordnet ist, die auf den Sensor gerichtet ist und auf diesem eine der Saugpipette mit dem Bauelement entsprechende Schattenlänge erzeugt. Eine Pipette, die kein Bauelement aufweist, oder die mit einem Bauelement unterschiedlichen Typs bestückt ist, erzeugt abweichende Sensorwerte, die einen entsprechenden Fehler indizieren. Bei einem fehlenden oder falschen Bauelement unterbleibt der nachfolgende Bestückvorgang, wodurch ein z.B. das Verschmutzen der leeren Pipettenspitze mit Lötpaste vermieden wird. Die falschen Bauelementen werden aussortiert.

Da nach jedem Pipettenwechsel zunächst die leere Saugpipette ohne Bauelement vermessen wird, kann die genaue Höhenlage der Pipettenspitze im Register abgespeichert werden, so daß Abmessungsunterschiede und Einbautoleranzen der Saugpipette bei der späteren Auswertung berücksichtigt werden können. Da sich die Sensorwerte analog zur Länge der Abschattung ändern ist es möglich, auch die Höhe des Bauelementes über der Pipettenspitze zu errechnen, was Rückschlüsse auf den Typ des gehaltenen Bauelementes ermöglicht.

Bei dem erfindungsgemäßen Verfahren ergeben sich deutliche Unterschiede zwischen den Vergleichswerten der Pipette mit bzw. ohne Bauelement. Dadurch ist es möglich, die Überprüfung "fliegend" durchzuführen, indem die Pipette mit dem Bauelement mit relativ großer gleichmäßiger Geschwindigkeit an dem Sensor vorbeibewegt wird, so daß die Vermessung nur einen geringen Zeitaufwand erfordert. Wird die Meßeinrichtung in den Bewegungsweg der Saugpipette gelegt, ist es möglich, den Zeitverlust weitgehend zu vermeiden.

Vorteilhafte Weiterbildungen der Erfindung sind in den Unteransprüchen gekennzeichnet:

Bei der Weiterbildung nach Anspruch 2 ruft ein Steuerprogramm die dem jeweils verwendeten Pipettentyp zugeordneten Nennwerte auf und vergleicht diese mit den Meßwerten der jeweiligen leeren Saugpipette. Wenn diese Meßwerte außerhalb eines zulässigen Toleranzbereiches liegen, ist davon auszugehen, daß es sich dabei entweder um einen anderen Pipettentyp handelt oder daß die Pipette fehlerhaft motiert wurde. In diesem Fall wird die Pipette verworfen und durch eine andere ersetzt, was die Funktionssicherheit des Bestückautomaten erhöht.

Durch das Abspeichern der Meßwerte der montierten Saugpipetten können die Höhenunterschiede der Saugpipetten bei der Auswertung der späteren Arbeitsdaten berücksichtigt werden.

Die Weiterbildung nach Anspruch 3 ermöglicht es, verschiedene Bauelementetypen nach ihrer Höhe zu identifizieren und ggf. in einem nachfolgenden Arbeitsgang zu verwerfen.

Durch die Weiterbildung nach Anspruch 4 ist es möglich, die Bauelemente auch nach ihrer der Bewegungsrichtung entsprechenden Länge zu erfassen und zu identifizieren.

Die Vorrichtung nach Anspruch 6 ermöglicht in einfacher Weise die Durchführung des erfindungsgemäßen Verfahrens.

Der Sensor nach Anspruch 7 kann kostengünstig hergestellt und genau ausgewertet werden. Die Schlitzmaske kann z.B. in einer Fensterbreite von 0,1 mm versehen werden, so daß selbst Bauelemente von 0,3 mm Breite hinreichend genau und sicher vermessen werden können.

Beim Bestückkopf nach Anspruch 8 wird die Relativbewegung zwischen dem Sensor und den Saugpipetten durch Verdrehen des Rotors erzeugt. Dadurch ist es möglich, die entsprechenden Prüfvorgänge während des Transportierens und Bestückens der Bauelemente zeitsparend durchzuführen. Die Anordnung des Sensors zwischen zwei Haltestation ermöglicht eine fliegende Vermessung des Bauelements mit gleichbleibender Geschwindigkeit und ohne Zeitverlust.

Die Weiterbildung nach Anspruch 9 ermöglicht eine letzte Überprüfung der Bauelemente unmittelbar vor dem Aufsetzen auf die Leiterplatte. Dadurch wird vermieden, daß bei einem vorangehenden Bauelementeverlust eine nicht leere pipette in die Lotpaste eintaucht. In einem solchen Fall könnten die Saugöffnungen der Pipette bis zum Verschluss kontaminiert werden.

Die Anordnung nach Anspruch 10 ermöglicht einen geringen Abstand zwischen dem Sensor und der Pipette, was die Abbildungsgenauigkeit erhöht.

Im Folgenden wird die Erfindung anhand eines in der Zeichnung dargestellten Ausführungbeispieles näher erläutert.
- Figur 1: zeigt eine Seitenansicht eines Mehrfachbestückkopfes,
- Figur 2: eine andere Seitenssansicht des Bestückkopfes nach Figur 1,
- Figur 3: einen Teilschnitt durch den Bestückkopf entlang der Linie III - III in Figur 2, mit einem optischen Sensor,
- Figur 4: eine Messwertekurve des Sensors nach Figur 3.

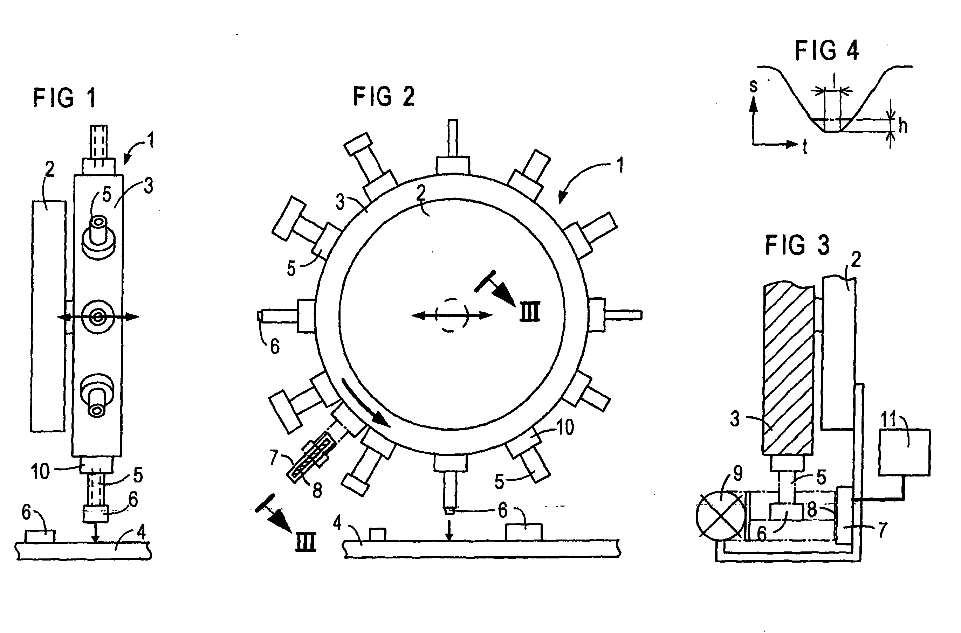

Nach den Figuren 1 und 2 besteht ein revolverartiger Bestückkopf 1 aus einem Stator 2 und einem an diesem drehbar gelagerten Rotor 3. Der Bestückkopf ist in den durch die Doppelpfeile angedeuteten Koordinatenrichtungen über einem als Leiterplatte 4 ausgebildeteten Bauelementeträger verfahrbar.

Der Rotor 3 weist eine Vielzahl von sternförmig abstehenden Saugpipetten 5 auf, die an drehsymmetrisch angeordneten einheitlichen Halterungen 10 des Bestückkopfes 1 austauschbar gelagert sind und an deren Saugenden elektrische Bauelemente 6 gehalten sind. Gemäß dem Rundpfeil können die Bauelemente durch indexiertes Drehen des Rotors 3 entsprechend der Pipettenteilung sukzessive in ihre Aufsetzposition über der Leiterplatte 4 verdreht werden. In einer Winkelstellung zwischen zwei der Aufsetzstation vorangehenden Haltestationen ist ein optischer Sensor 7 angeordnet, der eine linienartige Sensorfläche 8 aufweist, die sich parallel zur Achsrichtung der strichpunktiert angedeuteten vorbeidrehenden Saugpipette 5 erstreckt.

Nach Figur 3 sind der Sensor 7 und eine Lichtquelle 9 fest mit dem Stator 2 verbunden, wobei die Lichtquelle 9 auf der dem Sensor 7 diametral gegenüberliegenden Seite der Saugpipette 5 angeordnet und als Parallellichtquelle ausgebildet ist, deren ausgesendetes Licht senkrecht zur Drehebene der Saugpipetten 5 gerichtet ist. Die Lichtquelle 9 und der Sensor 7 sind derart angeordnet, daß das Ende der Saugpipette und das daran haftende Bauelement 6 vollständig in den Bereich der Sensorfläche 8 hineinragen. Diese wird nun entsprechend der Länge der Saugpipette 5 plus der Höhe des Bauelementes 6 abgeschattet.

Der Sensor 7 ist als Flächensensor ausgebildet, der mit einem schmalen Fenster versehen ist. Da sich die Messwerte des Sensors anlog zur abgeschatteten Länge verändern, können diese Messwerte zur Höhenbestimmung des Bauelementes in einer mit dem Sensor 7 verbundenen elektronischen Auswerteinrichtung 11 herangezogen werden.

Figur 4 zeigt ein Diagramm der sich über der Zeit t ändernden Sensorwerte s beim kontinuierlichen Vorbeifahren der mit einem Bauelement bestückten Saugpipette am Sensor 7 nach Figur 2, wobei der strichpunktierte Abschnitt die Sensorwerte einer leeren Saugpipette ohne angesetztes Bauelement darstellt. Entsprechend der empfangenen Lichtintensität zeigt die Kurve einen hohen Anfangswert. Sobald die Saugpipette mit dem Bauelement den Liniensensor abzuschatten beginnt, sinken diese Werte solange ab, bis sich die Saugpipette und das Bauelement in voller Länge im Bereich der Sensorfläche 8 befinden. Entsprechend der in der Bewegungsrichtung liegenden Länge des Bauelementes bleiben die Sensorwerte im Abschnitt 1 unverändert und steigen mit anschließender geringer werdender Überdeckung wieder an. Aus der Länge des gleichbleibenden Abschnitts 1 der Meßkurve können Rückschlüsse auf die tatsächliche Länge des Bauelements gezogen werden.

Aus dem Höhenunterschied h zwischen der strichpunktierten Linie und dem Abschnitt 1 läßt sich ferner der Höhenunterschied zwischen der bestückten und unbestückten Saugpipette ermitteln und damit die Höhe des Bauelementes berechnen. Dieser Unterschied kann somit nicht nur für die Anwesenheitskontrolle, sondern auch für die Überprüfung des Bauelementtypes herangezogen werden.

## Patentansprüche

1. Verfahren zum optischen Überprüfen eines elektrischen Bauelementes (6), das an einer Saugpipette (5) eines Bestückkopfes (1) eines Bestückautomaten zur Bestückung von Bauelementeträgern (4) gehalten wird,
wobei auf einem optischen Sensor (7) im Durchlicht einer diametral gegenüberliegende Lichtquelle (9) ein Schattenwurf zumindest eines Teiles des Bauelementes (6) erzeugt und in einer mit dem Sensor (7) verbundenen elektronischen Auswerteeinrichtung (11) ausgewertet wird,
wobei das freie Ende der Saugpipette (5) mit dem daran gehaltenenen Bauelement (6) in den Erfassungsbereich des als Liniensensor ausgebildeten Sensors (7) bewegbar ist und
wobei die Saugpipette (5) in eine relativ zum Sensor (7) definierte Lage gebracht wird,
**dadurch gekennzeichnet, daß** zu diesem Zeitpunkt die Achsrichtung der Saugipette parallel zur Längsrichtung des Liniensensors ausgerichtet wird,
daß der Sensor (7) die Länge der Abschattung durch die Saugpipette (5) und das Bauelement (6) ermittelt,
daß die zuvor in gleicher Weise ermittelten Abschattungswerte der leeren Saugpipette (5) in einem elektronischen Register der Auswerteeinrichtung gespeichert werden,
daß in der Auswerteeinrichtung (11) die Registerwerte mit den aktuell gemessenen Sensorwerten der Saugpipette (5) inklusive Bauelement (6) verglichen werden und
daß aus den entsprechenden Abweichungen die Anwesenheit und/oder die Höhe des Bauelementes (6) ermittelt wird.

2. Verfahren nach Anspruch 1,
**dadurch gekennzeichnet,**
**daß** der Bestückkopf mit einer Halterung (10) für Saugpipetten (5) unterschiedlichen Typs versehen ist,
**daß** die Halterung (10) in eine zum Sensor (7) gleichbleibende relative Lage gebracht wird,
**daß** Sensorwerte der unterschiedlichen Typen von leeren Saugpipetten (5) hinsichtlich der Abschattung ermittelt und als typspezifische Nennwerte im elektronischen Register bleibend gespeichert werden,
**daß** nach jedem Pipettenwechsel die jeweilige exakte Höhenlage der leeren Pipettenspitze anhand der Abschattung ermittelt und als separate Registerwerte abgespeichert wird und
**daß** diese Registerwerte in der Auswerteeinrichtung (11) mit den zugehörigen typspezifischen Nennwerten verglichen werden.

3. Verfahren nach Anspruch 1 oder 2,
**dadurch gekennzeichnet,**
**daß** Kennwerte der einzelnen Typen der Bauelemente (6) hinsichtlich der Abschattung ebenfalls in dem Register gespeichert werden und
**daß** aus dem Vergleich der Registerwerte der Saugpipette (5) und der Kennwerte des Bauelementes (6) mit den gemessenen Sensorwerten die Identität des Bauelementes (6) überprüft wird.

4. Verfahren nach Anspruch 1,2 oder 3,
**dadurch gekennzeichnet,**
**daß** die Saugpipette an dem Sensor (7) vorbeibewegt wird,
**daß** das Durchlicht transversal zur Bewegungsrichtung der Saugpipette (5) orientiert ist,
**daß** die Abschattungswerte in mehreren eng aufeinanderfolgenden Bewegungsphasen der Saugpipette ermittelt werden und
**daß** die Auswerteeinrichtung aus der zeitlichen Änderung der Sensorwerte in Bezug auf die Wegänderung des vorbeibewegten Bauelementes (6) dessen sich in der Bewegungsrichtung erstreckende Länge ermittelt.

5. Verfahren nach Anspruch 4,
**dadurch gekennzeichnet,**
**daß** die Saugpipette (5) mit einer gleichbleibenden Geschwindigkeit am Sensor (7) vorbeibewegt wird und
**daß** die Länge des Bauteils in Anhängigkeit von der zeitlichen Änderung der Sensorwerte ermittelt wird.

6. Vorrichtung zur Durchführung des Verfahrens nach einem der vorhergehenden Ansprüche ,
wobei die Vorrichtung zur Bestückung von Bauelementeträgern (4) mit elektrischen Bauelementen (6) einen Bestückkopf (1) mit einer Saugpipette (5) zum Halten eines der elektrischen Bauelemente(6) aufweist, das zusammen mit dem freien Ende der Saugpipette (5) zwischen einen optischen Sensor (7) und eine diesem gegenüberliegende Lichtquelle (9) bewegbar ist, die einen Schattenwurf zumindest eines Teiles des Bauelementes (6) auf dem als Liniensensor ausgebildeten Sensor (7) erzeugt,
wobei die Saugpipette (5) relativ zum Sensor (7) eine definierte Lage einnimmt und
wobei der Sensor (7) mit einer elektronischen Auswerteeinrichtung (11) verbunden ist,
**dadurch gekennzeichnet,**
**daß** die Saugpipette (5) mit dem Bauelement (6) zwischen der Lichtquelle (9) und dem Sensor (7) hindurch bewegbar ist und **daß** zu dem Zeitpunkt, in dem die Saugpipette mit dem Bauelement den Erfassungsbereich des Liniensensors erreicht, die Achsrichtung der Saugipette parallel zur Längsrichtung des Liniensensors ausgerichtet ist.

7. Vorrichtung nach Anspruch 6,
**dadurch gekennzeichnet,**
**daß** der Sensor (7) als Flächensensor ausgebildet ist, der mit einer geradlinigen schmalen Schlitzmaske versehen ist und
**daß** die detektierten Sensorwerte sich analog zur Länge der Abschattung ändern.

8. Vorrichtung nach einem der Ansprüche 6 oder 7,
**dadurch gekennzeichnet,**
**daß** der Sensor (7) zusammen mit der Lichtquelle (9) an einem Stator des als Revolverkopf ausgebildeten Bestückkopfes befestigt ist,
**daß** ein indexiert antreibbarer Rotor des Bestückkopfes eine Vielzahl der zirkulär verteilten Saugpipetten (5) trägt und
**daß** der Sensor (7) zwischen zwei Haltestationen der Saugpipetten (5) angeordnet ist.

9. Vorrichtung nach Anspruch 8,
**dadurch gekennzeichnet,**
**daß** der Sensor (7) in der Nähe vor einer Aufsetzstation des Bestückkopfes für die Bauelemente (6) angeordnet ist.

10. Vorrichtung nach Anspruch 8 oder 9,
**dadurch gekennzeichnet,**
**daß** die Saugpipetten (5) am Rotor sternfömig abstehend angeordnet sind und
**daß** linienartige Sensorfläche(8) des Sensors (7) radial zur Drehachse des Rotors orientiert ist.

## Claims

1. Method for optically checking an electric component (6) which is held on a suction pipette (5) of a component insertion head (1) of a component insertion machine for populating component carriers (4),
a shadow of at least part of the component (6) being produced on an optical sensor (7) in the transmitted light from a light source (9) arranged diametrically opposite, and evaluated in an electronic evaluation device (11) connected to the sensor (7),
the free end of the suction pipette (5) with the component (6) held thereon being capable of moving into the registration area of the sensor (7), designed as a linear sensor, and
the suction pipette (5) being brought into a defined position relative to the sensor (7),
**characterized in that** at this time, the axial direction of the suction pipette is aligned parallel to the longitudinal direction of the linear sensor,
**in that** the sensor (7) determines the length of the shadow cast by the suction pipette (5) and the component (6),
**in that** the values, determined in advance in the same manner, of the shadow cast by the empty suction pipette (5) are stored in an electronic register in the evaluation device,
**in that**, in the evaluation device (11), the register values are compared with the currently measured sensor values from the suction pipette (5) including the component (6), and
**in that** the presence and/or the height of the component (6) is determined from the corresponding deviations.

2. Method according to Claim 1, **characterized in that** the component insertion head is provided with a holder (10) for suction pipettes (5) of different types,
**in that** the holder (10) is brought into a constant position relative to the sensor (7),
**in that** sensor values of the different types of empty suction pipettes (5) are determined with respect to the shadow cast and are permanently stored as type-specific nominal values in the electronic register,
**in that** following each pipette change, the respective exact vertical position of the empty pipette tip is determined by using the shadow cast and is stored as separate register values, and
**in that** these register values are compared in the evaluation device (11) with the associated type-specific nominal values.

3. Method according to Claim 1 or 2, **characterized in that** characteristic values of the individual types of the components (6) with regard to the shadow cast are likewise stored in the register, and
**in that** from the comparison of the register values of the suction pipette (5) and the characteristic values of the component (6) with the measured sensor values, the identity of the component (6) is checked.

4. Method according tc Claim 1, 2 or 3, **characterized in that** the suction pipette is moved past the sensor (7),
**in that** the transmitted light is oriented transversally with respect to the direction of motior of the suction pipette (5),
**in that** the values of the shadows cast are determined in a plurality of closely successive movement phases of the suction pipette, and
**in that** the evaluation device uses the time change of the sensor values in relation to the distance changs of the component (6) moved past to determine the length of the latter extending in the direction of motion.

5. Method according to Claim 4, **characterized in that** the suction pipette (5) is moved past the sensor (7) at a constant speed, and
**in that** the length of the component is determined as a function of the time change of the sensor values.

6. Device for carrying out the method according to one of the preceding claims,
the device for populating component carriers (4) with electric components (6) having a component insertion head (1) with a suction pipette (5) for hclding one of the electric components (6) which, together with the free end of the suction pipette (5), can be moved between an optical sensor (7) and a light source (9) located opposite the latter, producing a shadow of at least part of the component (6) on the sensor (7) designed as a linear sensor,
the suction pipette (5) assuming a defined position relative to the sensor (7), and
the sensor (7) being connected to an electronic evaluation device (11),
**characterized in that** the suction pipette (5) with the component (6) can be moved through between the light source (9) and the sensor (7), and
**in that** at the time at which the suction pipette with the component reaches the registration area of the linear sensor, the axial direction of the suction pipette is aligned parallel to the longitidinal direction of the linear sensor.

7. Device according to Claim 6, **characterized in that** the sensor (7) is designed as a two-dimensional sensor which is provided with a rectilinear, narrow slot mask and
**in that** the detected sensor values change in an analogous way to the length of the shadow cast.

8. Device according to either of Claims 6 and 7, **characterized in that** the sensor (7) together with the light source (9) is fixed to a stator of the component insertion head, constructed as a turret head,
**in that** an indexable rotor of the component insertion head carries a large number of the circularly distributed suction pipettes (5) and
**in that** the sensor (7) is arranged between two holding stations of the suction pipettes (5).

9. Device according to Claim 8, **characterized in that** the sensor (7) is arranged in the vicinity before a placement station of the component insertion head for the components (6).

10. Device according to Claim 8 or 9, **characterized in that** the suction pipettes (5) are arranged on the rotor so as to project in a star shape, and
**in that** the linear sensor area (8) of the sensor (7) is oriented radially with respect to the axis of rotation of the rotor.

## Revendications

1. Procédé pour le contrôle optique d'un composant électrique (6), maintenu sur une pipette d'aspiration (5) d'une tête de mise en place de composants (1) d'un automate de mise en place de composants servant à la mise en place de porte-composants (4),
une projection d'ombre d'au moins une partie du composant (6) étant produite sur un capteur optique (7) par transmission d'une source lumineuse (9) diamétralement opposée et étant évaluée dans un dispositif d'évaluation électronique (11) relié au capteur (7),
l'extrémité libre de la pipette d'aspiration (5) étant déplaçable avec le composant (6) maintenu sur celle-ci dans la zone de détection du capteur (7) conçu comme capteur linéaire
et la pipette d'aspiration (5) étant amenée dans une position définie relativement au capteur (7),
**caractérisé en ce que** à ce moment le sens de l'axe de la pipette d'aspiration est orienté parallèlement au sens longitudinal du capteur linéaire,
**en ce que** le capteur (7) détermine la longueur de l'ombre par la pipette d'aspiration (5) et le composant (6),
**en ce que** les valeurs d'ombre de la pipette d'aspiration vide (5) déterminées auparavant de la même manière sont mémorisées dans un registre électronique du dispositif d'évaluation,
**en ce que** dans le dispositif d'évaluation (11) les valeurs du registre sont comparées aux valeurs du capteur de la pipette d'aspiration (5) incluant le composant (6) mesurées actuellement, et
**en ce que** la présence et/ou la hauteur du composant (6) est déterminée à partir des écarts correspondants.

2. Procédé selon la revendication 1, **caractérisé en ce que**, la tête de mise en place de composants est pourvue d'un support (10) pour pipettes d'aspiration (5) d'un type différent, **en ce que** le support (10) est amené en une position relative constante par rapport au capteur (7),
**en ce que** les valeurs du capteur des différents types de pipettes d'aspiration vides (5) sont déterminées en ce qui concerne l'ombre et mémorisées de façon permanent dans le registre électronique comme valeurs nominales spécifiques à un type,
**en ce que** après chaque changement de pipette la position en hauteur exacte respective de la pointe de la pipette vide est déterminée à l'aide de l'ombre et mémorisée comme valeur du registre séparées et
**en ce que** ces valeurs du registre sont comparées dans le dispositif d'évaluation (11) avec les valeurs nominales spécifiques à un type afférentes.

3. Procédé selon la revendication 1 ou 2,
**caractérisé en ce que** des valeurs caractéristiques des différents types de composants (6) sont mémorisées également dans le registre en ce qui concerne l'ombre et
**en ce que** l'identité du composant (6) est contrôlée à partir de la comparaison des valeurs du registre de la pipette d'aspiration (5) et des valeurs caractéristiques du composant (6) avec les valeurs mesurées du capteur.

4. Procédé selon la revendication 1, 2 ou 3
**caractérisé en ce que** la pipette d'aspiration est déplacée à côté du capteur (7), **en ce que** la lumière transmise est orientée transversalement au sens de déplacement de la pipette d'aspiration (5),
**en ce que** les valeurs d'ombre sont déterminées en plusieurs phases de déplacement successives et rapprochées de la pipette d'aspiration et
**en ce que** le dispositif d'évaluation détermine la longueur du composant s'étendant dans le sens du déplacement à partir de la variation dans le temps des valeurs du capteur en rapport avec le changement de course du composant (6) déplacé à côté de celui-ci.

5. Procédé selon la revendication 4,
**caractérisé en ce que** la pipette d'aspiration (5) est déplacée à côté du capteur (7) à une vitesse constante et
**en ce que** la longueur de composant est déterminée en fonction de la variation dans le temps des valeurs du capteur.

6. Dispositif pour l'exécution du procédé selon l'une des revendications précédentes,
le dispositif pour la mise en place de porte-composants (4) avec des composants électriques (6) comportant une tête de mise en place des composants (1) équipée d'une pipette d'aspiration (5) pour le maintien de l'un des composants électrique (6), déplaçable avec l'extrémité libre de la pipette d'aspiration (5) entre un capteur optique (7) et une source lumineuse (9) opposée à celui-ci, qui produit une projection de lumière d'au moins une partie du composant (6) sur le capteur conçu comme capteur linéaire (7),
la pipette d'aspiration (5) prenant une position définie par rapport au capteur (7) et
le capteur (7) étant relié à un dispositif d'évaluation électronique (11), **caractérisé en ce que** la pipette d'aspiration (5) est déplaçable avec le composant (6) entre la source lumineuse (9) et le capteur (7) et **en ce qu'**au moment auquel la pipette d'aspiration avec le composant atteint la zone de détection du capteur linéaire, le sens de l'axe de la pipette d'aspiration est orienté parallèlement au sens longitudinal du capteur linéaire.

7. Dispositif selon la revendication 6,
**caractérisé en ce que** le capteur (7) est conçu comme capteur plat, pourvu d'un masque fendu étroit rectiligne et
**en ce que** les valeurs du capteur détecté varient par analogie avec la longueur de l'ombre.

8. Dispositif selon l'une des revendications 6 ou 7,
**caractérisé en ce que** le capteur (7) avec la source lumineuse (9) est fixé à un stator de la tête de mise en place des composants conçu comme tête revolver, **en ce qu'** un rotor indexé entraînable de la tête de mise en place de composants porte une pluralité de pipettes d'aspiration (5) réparties circulairement et
**en ce que** le capteur (7) est disposé entre deux stations de maintien des pipettes d'aspiration (5).

9. Dispositif selon la revendication 8,
**caractérisé en ce que** le capteur (7) est disposé à la proximité d'une station de dépose de la tête de mise en place de composants (6).

10. Dispositif selon la revendication 8 ou 9,
**caractérisé en ce que** les pipettes d'aspiration (5) sont disposées en étoile de manière espacée sur le rotor et
**en ce que** la surface linéaire (8) du capteur (7) est orientée radialement par rapport à l'axe de rotation du rotor.
